(19)

Europäisches Patentamt

European Patent Office

Office européen des brevets

(11) **EP 4 387 259 B1**

(12) **EUROPEAN PATENT SPECIFICATION**

(45) Date of publication and mention
of the grant of the patent:
**03.09.2025 Bulletin 2025/36**

(21) Application number: **22306864.4**

(22) Date of filing: **13.12.2022**

(51) International Patent Classification (IPC):
$H04N\ 25/47^{(2023.01)}$    $H04N\ 19/93^{(2014.01)}$
$H04N\ 19/90^{(2014.01)}$    $H03M\ 7/48^{(2006.01)}$
$H04N\ 25/78^{(2023.01)}$    $H03M\ 7/30^{(2006.01)}$

(52) Cooperative Patent Classification (CPC):
**H04N 25/47; H03M 7/6047; H04N 25/78**

(54) **ROW SELECTION METHOD FOR EVENT-BASED IMAGE SENSOR READOUT**

ZEILENAUSWAHLVERFAHREN FÜR AUSLESEN EINES EREIGNISBASIERTES BILDSENSORS

PROCEDE DE SELECTION DE LIGNE POUR LA LECTURE DE CAPTEURS D'IMAGE SUR BASE D'EVENTS

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**

(43) Date of publication of application:
**19.06.2024 Bulletin 2024/25**

(73) Proprietor: **Prophesee**
**75012 Paris (FR)**

(72) Inventors:
• **MATOLIN, Daniel**
**01705 FREITAL (DE)**
• **POSCH, Christoph**
**2721 BAD FISCHAU (AT)**

(74) Representative: **Regimbeau**
**20, rue de Chazelles**
**75847 Paris Cedex 17 (FR)**

(56) References cited:
WO-A1-2021/125031    US-A1- 2018 262 665
US-A1- 2019 096 081    US-A1- 2021 258 525
US-A1- 2023 039 270

• **GOLUBCOVS STANISLAVS ET AL: "Generalised Asynchronous Arbiter", 2019 19TH INTERNATIONAL CONFERENCE ON APPLICATION OF CONCURRENCY TO SYSTEM DESIGN (ACSD), IEEE, 23 June 2019 (2019-06-23), pages 3 - 12, XP033618802, DOI: 10.1109/ACSD.2019.00005**
• **YANG YUNING ET AL: "A configurable realtime DWT-based neural data compression and communication VLSI system for wireless implants", JOURNAL OF NEUROSCIENCE METHODS, ELSEVIER SCIENCE PUBLISHER B.V., AMSTERDAM, NL, vol. 227, 5 March 2014 (2014-03-05), pages 140 - 150, XP028841458, ISSN: 0165-0270, DOI: 10.1016/ J.JNEUMETH.2014.02.009**
• **CHI Y M ET AL: "CMOS Camera With In-Pixel Temporal Change Detection and ADC", IEEE JOURNAL OF SOLID-STATE CIRCUITS, IEEE, USA, vol. 42, no. 10, 1 October 2007 (2007-10-01), pages 2187 - 2196, XP011193056, ISSN: 0018-9200, DOI: 10.1109/JSSC.2007.905295**
• **CHETAN SINGH THAKUR ET AL: "Large-Scale Neuromorphic Spiking Array Processors: A quest to mimic the brain", ARXIV.ORG, CORNELL UNIVERSITY LIBRARY, 201 OLIN LIBRARY CORNELL UNIVERSITY ITHACA, NY 14853, 23 May 2018 (2018-05-23), XP081234511**

EP 4 387 259 B1

**Description**

TECHNICAL FIELD

The invention relates to a method for operating an event-based image sensor, also called neuromorphic sensor.

BACKGROUND OF THE INVENTION

In conventional video cameras, the apparatus records photogram after photogram. In event-based image sensors, there are no photograms. Like in video cameras, the integrated circuit contains a photo sensor matrix. However, in conventional video cameras, each photo sensor is sampled at a fixed frequency, whereas in temporal contrast sensors, pixels are not sampled: each pixel calculates the intensity change of the light it senses, optionally performs some processing on this intensity change, and when the calculated quantity exceeds a defined level or threshold, the pixel generates an "analog pixel event", or APE.

The APE must be processed to transmit the information that a light intensity change occurred on the pixel from which the APE originates. A readout is performed to transmit the APE in the form of digital events to a processing pipeline in which various processing are performed, for example filtering, formatting, packetizing, interfacing, etc... Some processing elements such as filters, and especially spatiotemporal filter and anti-flickering, require accessing to data related to the pixel which has been previously stored in memory. For instance, US 2021/258525 A1 suggests using an arbiter circuit to prioritize the requests. Many memory accesses are involved, implying a huge power consumption, especially since the memory is typically SRAM (static random-access memory). SRAM has low idle power consumption but high operational power consumption. The power consumption of SRAM is therefore directly correlated to how frequently it is accessed.

In order to achieve a good rendering to the image dynamics, the sensor is configured so that even tiny light changes might trigger APE in at least one pixel. In addition, always desired higher resolutions mean that more pixels generate events. Consequently, many events must be processed every second, involving many memory accesses. As a result, the sensor experiences a substantial power consumption.

Accordingly, there is a need for an event-based image sensor with a reduced power consumption, without sacrificing resolution or sensitivity.

SUMMARY OF THE INVENTION

The invention relates to a method for operating an event-based image sensor comprising a plurality of pixel circuits arranged in rows and columns to form a pixel array, each pixel circuit being arranged at a location defined by an address, wherein each pixel circuit is configured to detect an illumination change in a photoreceptor signal derived from a photocurrent generated by a light impinging on a light-sensitive element of said pixel circuit and to consequently activate a row request, wherein the pixel array comprises a readout circuit coupled to the pixel circuits by row lines, said readout circuit configured to receive the row request from the pixel circuits and to interact with the pixel circuits to read and reset said pixel circuits,

wherein during a readout cycle, a plurality of pixel circuits are read and reset on a row-by-row basis by the readout circuit, and wherein:

- at the beginning of the readout cycle, the row requests which are activated at said beginning are sampled into activated sampled row requests,
- the activated sampled row requests are selected by an organizer, and in each row with a selected sampled activated row request, each pixel circuit with an activated row request is read and reset before another row with a sampled activated row request is selected, until all the sampled activated row requests have been selected,

wherein the rows are associated with a row order, and the organizer selects the sampled activated row requests in a sequence organized by a predetermined rule and based on respective positions of the rows with sampled activated row requests in the row order.

Other preferred, although non-limitative, aspects of the invention are as follows, isolated or in a technically feasible combination:

- the sequence in which the activated sampled row requests are selected is independent of an order in which row requests were activated;
- the predetermined rule organizing the sequence comprises a descending order or an ascending order;

- during a readout cycle, newly activated row requests are not sampled into activated sampled row requests, due to an empty arbiter signal indicating that the organizer is not empty;
- the readout circuit comprises an input logic to which are coupled the row lines, said readout circuit configured to sense a row request on at least one row line and to send a row request indicator to a state machine to indicate that at least one row line has a row request, thereby starting the readout cycle;
- the row requests which are activated at the beginning of the readout are translated into derived row requests by an input logic of the readout circuit, and said derived row requests are then sampled into activated sampled row requests, wherein the translation of a row request into a derived row request is conditioned by a selection of the row to which are associated said row request, through a selection signal;
- the state machine is configured to send a sampling request to an interface, said interface configured to, in response to said row request, sample the row requests on the row lines, said sampling request being synchronous with a clock signal;
- the sampling request is generated by the state machine in response to the row request indicator, to a read confirmation that a column interface is ready to read pixel circuits a new row, and/or is generated periodically during the readout of pixel circuits of a row;
- the sampling request is generated by the state machine in synchronicity with a frame rate defined by an external signal.

## BRIEF DESCRIPTION OF THE DRAWINGS

Other aspects, objects and advantages of the present invention will become better apparent upon reading the following detailed description of preferred embodiments thereof, given as non-limiting examples, and made with reference to the appended drawings wherein:

- Fig. 1 shows a simplified diagram of a pixel array of an event-based image sensor according to a possible embodiment of the invention;
- Fig. 2 shows a simplified diagram of the structure of a pixel of a pixel array of an event-based image sensor according to a possible embodiment of the invention;
- Fig. 3 shows a simplified diagram of the interactions between components of a row selector according to a possible embodiment of the invention;
- Fig. 4 shows an example of a state diagram of the state machine;
- Fig. 5 shows a timing diagram showing how various signals change in a simplified example of operation where only three rows are concerned;
- Fig. 6 shows a schematic example of the circuit at a row level of the input logic;
- Fig. 7 shows a schematic example of a circuit of the interface at row level;
- Fig. 8 shows a simplified schematic diagram of an example of an arbiter tree for row selection;
- Fig. 9 shows a possible embodiment of a circuit of an arbiter cell in the arbiter tree of Fig. 8 with four request inputs and four acknowledge outputs which are multiplexed;
- Fig. 10 shows a possible embodiment of a compressed event packet data format using a 18-bit word comprising a 2-bit header and a 16-bit payload;
- Fig. 11 is an example of a sensor matrix showing the generation of a compressed frame in the global synchronous operation mode during pixel array readout.

## DETAILED DESCRIPTION OF THE INVENTION

In this disclosure, "row" and "column" refer to two different dimensions of the readout periphery, the naming of which is arbitrary. Both dimensions of the readout periphery can be swapped without changing the function of the readout periphery. For ease of explanation and without causing ambiguity, hereinafter, the first and second dimensions accessed by the pixel is referred to as "row" and "column," respectively, which are designated with dimension designators 'Y" and "X," respectively.

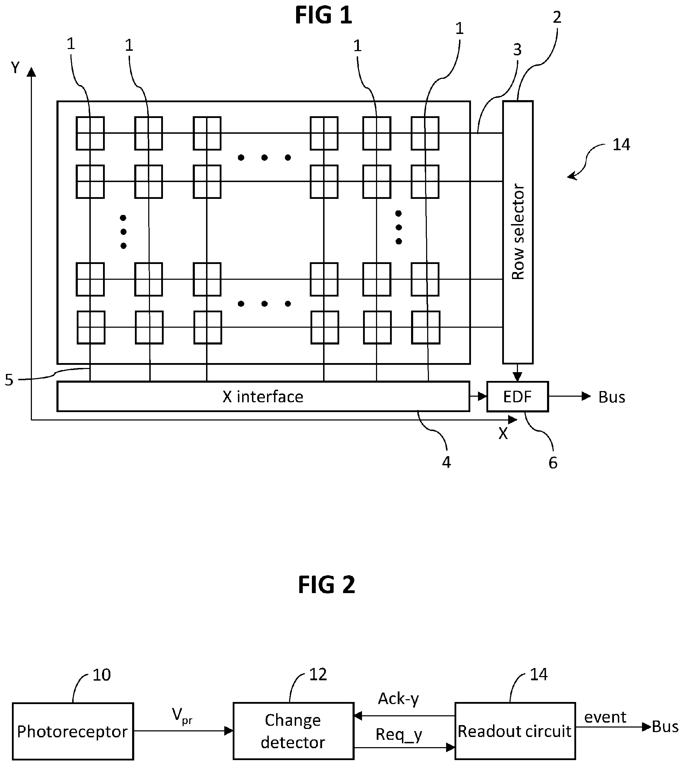

A simplified diagram of an event-based image sensor according to a possible embodiment is shown in **Fig. 1.** The event-based image sensor comprises a plurality of pixel circuits, or more simply pixels 1, forming a pixel array. **Fig. 1** shows a limited number of pixels 1 for clarity's sake. It is understood that the pixel array comprises a large number of pixels 1, with dimensions exceeding 256 x 256 pixels for example, and for example with a resolution of 1280 x 720 pixels.

As illustrated on **Fig. 2,** each pixel 1 comprises a photoreceptor circuit 10 configured for delivering a photoreceptor signal derived from the photocurrent generated by light impinging on a light-sensitive element of the photoreceptor 10, and a change detector 12 configured for detecting a change in the photoreceptor signal $V_{pr}$ derived from the photocurrent. A band-pass filter can be provided between the photoreceptor circuit 10 and the change detector 12 to filter the photoreceptor signal $V_{pr}$.

The light-sensitive element of the photoreceptor 10 is typically a photodiode and converts incident light into a photocurrent, determined by the light exposure of the light-sensitive element. The photoreceptor signal $V_{pr}$ is usually in a logarithmic relationship with the photocurrent. Typically, the photoreceptor signal $V_{pr}$ can be approximated as

$$V_{pr} = k_1 \ln(I_{pr}) + k_2$$

wherein $I_{pr}$ is the intensity of the photocurrent, $k_1$ and $k_2$ are constant factors. The instantaneous voltage value of the photoreceptor signal $V_{pr}$ relates logarithmically to the instantaneous intensity of the photocurrent, and consequently a measurement of the photoreceptor signal $V_{pr}$ allows to derive the light exposure level of the light-sensitive element of the photoreceptor circuit 10.

The change detector 12 is configured to detect a change in the photoreceptor signal $V_{pr}$. The change detector 12 continuously monitors the photoreceptor signal $V_{pr}$ for changes and emits a detection signal each time a change is detected. A detection signal identifies a fractional increase or decrease in the photoreceptor signal $V_{pr}$ that exceeds adjustable voltage thresholds. The change in the photoreceptor signal $V_{pr}$ is therefore translated into an analog pixel event, or APE, in the detection signal of a pixel.

An event is characterized at least by a polarity (indifferently designated as high/low, positive/negative, or ON/OFF) reflecting a direction of the change in the photoreceptor signal $V_{pr}$ caused by the APE. More precisely, the change detector 12 generates a high polarity event when the photoreceptor signal $V_{pr}$ increases, i.e. exceeds by a threshold a previous value, and the change detector 12 generates a low polarity event when the photoreceptor signal $V_{pr}$ decreases, i.e. comes below a threshold with respect to a previous value. A comparator is usually used to compare the instantaneous value of the photoreceptor signal $V_{pr}$ with a previous value used as a reference. An event is not only characterized by a polarity, but is also characterized by a pixel address constituted by the line and column coordinates (respectively x, y) of the pixel 1 in which the event is generated. An event is also generated or sent at a particular time, and may also be characterized by an occurrence time, which may be encoded in a time-stamp associated with said event. A change detector 12 that can be used for detecting changes in lighting intensity received by the pixels, for example in the case of dynamic vision sensor (DVS), is described in patents US 7,728,269 and US 8,780,240.

The pixel array comprises a readout circuit 14 coupled to the pixel circuits by row lines 3. The readout circuit 14 typically comprises several distinct modules, such as a row selector 2 coupled to the pixel circuits by the row lines 3 or a line interface 4 (or X interface) coupled to the pixel circuits 1 by column lines 5. The line interface 4 receives data such as column requests from the read pixel circuits 1 depending on the illumination changes, for example an ON column request for indicating a positive illumination change (i.e. an increase), and/or an OFF column request to indicate a negative illumination change (i.e. a decrease). The readout circuit 14 is configured to receive the row requests from the pixel circuits 1 and to interact with the pixel circuits 1 to read and reset said pixel circuits 1.

The readout circuit 14 may also comprise an event-data-formatter 6, or EDF, which is configured to receive the column data from the line interface 4 and the row addresses from the row selector 2. The event-data-formatter 6 formats the received data for transferring them to a bus for further processing. For instance, the event-data-formatter 6 encodes the received data into packets. The event-data-formatter 6 may also associate a time-stamp to the received data, for example corresponding to the time at which the row is selected or the row address is received, or a time at which an entire frame has been read, or corresponding to a time associated with an external readout signal, or more precisely an externally driven row request sampling signal. The timestamp may be generated by the event-data-formatter 6 or by a dedicated time stamper.

More specifically, the readout circuit 14 is configured to sample the row requests on the row lines, and the sampled row requests are sent to an organizer of the readout circuit 14. During a readout cycle, a plurality of pixel circuits 1 are read and reset on a row-by-row basis by the readout circuit 14. As long as sampled row requests are unacknowledged, the organizer determines which row is to be selected among the rows with an unacknowledged sampled row request based on a predetermined rule, and the pixel circuits 1 of the selected row with a row request are read, causing the row requests of the selected row to be acknowledged.

In a preferred embodiment, the organizer is an arbiter tree, which is a selector based on a tree structure. Other types of organizers could be used, such as a scanner to perform the selection of active rows or the latched rows in the interface. The arbiter tree is however particularly advantageous for a fast row selection especially when not a lot of rows are active.

In the following description, the organizer is an arbiter tree, and signals related to the organizer are labeled as arbiter signal. For instance, the empty organizer signal signaling that the organizer is empty is an empty arbiter signal. All the features and signals related to the arbiter tree are applicable to the organizer.

The row selection does not follow a simple scanning procedure in which all the rows are scanned, but uses certain pixel array signals to determine the active rows to be serviced and the optimal sequence of readout operation. The system is controlled by a state machine and benefits from sparsity in pixel activation by allowing to e.g. skip non-active parts of the array during a readout cycle. The inherent temporal precision of the event pixel data can be fully preserved.

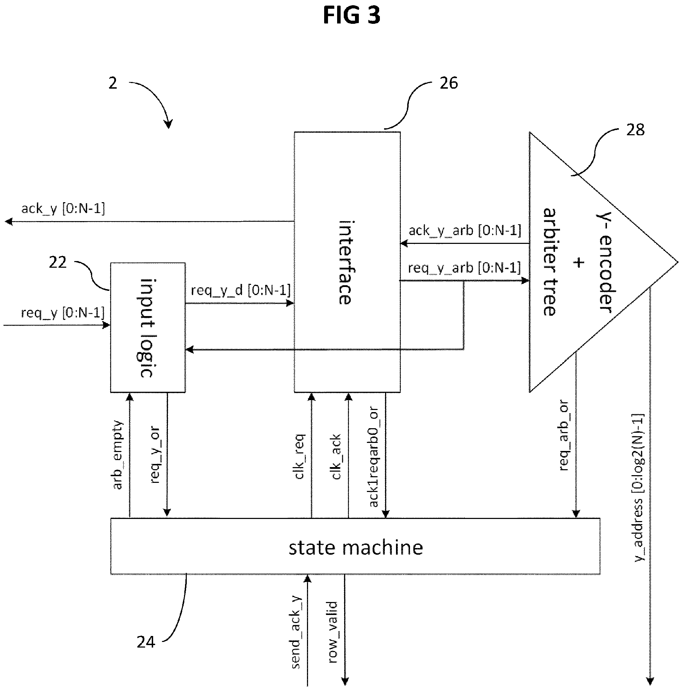

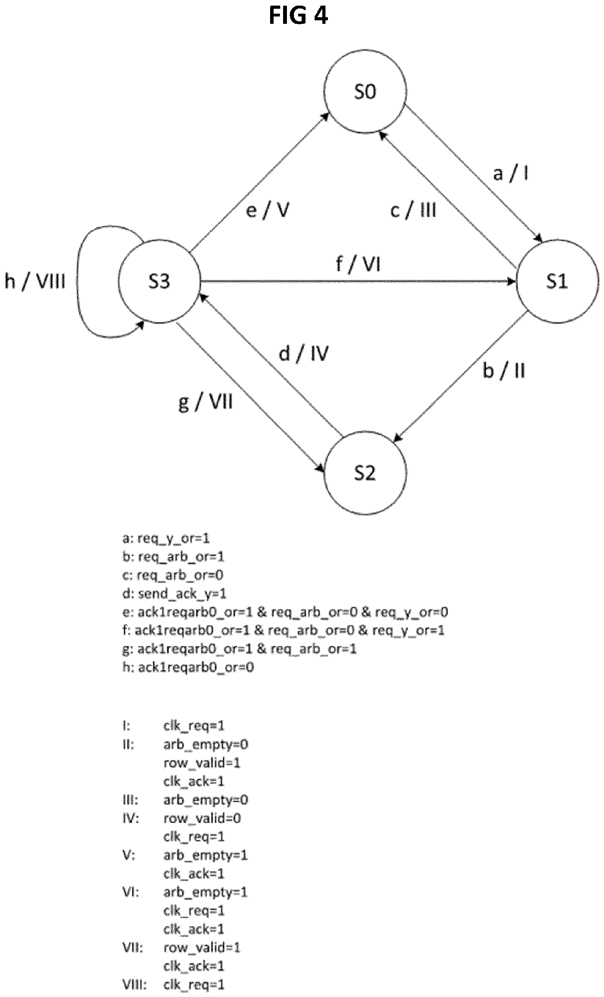

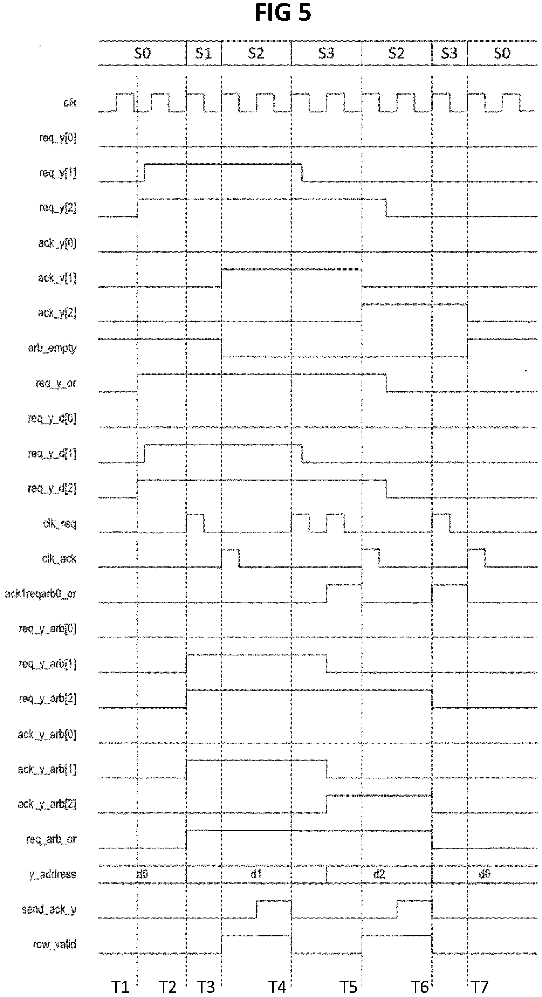

In reference to **Fig 3, Fig. 4,** and **Fig. 5,** an example of operation of an event-based image sensor will now be described. **Fig. 3** is a simplified diagram of the interactions between components of a row selector of the readout circuit. **Fig. 4** is a state diagram of state machine 24. The transition conditions are denoted with a letter, whereas the actions are denoted by Roman numerals. **Fig. 5** is an example of a waveform diagram for row selector operations, with an example of three rows. In this figure, a low level of a waveform corresponds to 0 or a deactivated state, whereas a high level of a waveform corresponds to an activated state, or 1. This convention is not limitative, and other conventions could be used, for example with a low level corresponding to an activated state or 1. In this example, the sensor is originally idle, and the row address y_address in **Fig. 5** is arbitrarily set at d0. The upper signal clk is a clock signal which oscillates between a high and a low state and is used like a metronome to coordinate actions of digital circuits. In this example, the clock signal clk has a conventional form of a square wave with a 50% duty cycle, at a fixed, constant frequency, but other waveforms could be used. In the following description, there are N rows, [n] refers to a specific row n, and [0;N-1] refers to all the rows in parallel. It shall be noted that clock-related signals such as the sampling request clk_req or the clock acknowledgement clk_ack may have a predetermined duration, typically the same duration as the clock signal. Those clock-related signals are triggers used to synchronize operations with the clock, and do not need to be deactivated.

Initially, the state machine 24 is in an idle state S0 in which the state machine 24 waits for a row request req_y to be generated. To this end, the state machine 24 may test a row request indicator req_y_or whose activated state indicates that at least one row request signal req_y is activated. If the row request indicator req_y_or is deactivated (i.e. req_y_or=0), there is no active row request signal req_y and the state machine stays in the idle state S0. The row request indicator req_y_or is for example managed by the input logic circuit 22, which receives all the row requests req_y and may generate the row request indicator req_y_or by a simple OR logical gates from the row requests req_y. Since no row request is being processed, the arbiter 28 is empty, and an empty arbiter signal arb_empty is therefore activated (i.e. arb_empty=1).

When an illumination change in the photoreceptor signal $V_{pr}$ is detected by the change detector 12 of a pixel circuit 1, a row request req_y is generated by said pixel circuit 1 on a row line 3 coupled to the readout circuit 14. Let's note req_y[n] the row request of the row n. In the example of **Fig. 5,** the illumination change is detected by a pixel of the third row at a first instant T1, and said pixel circuit 1 sets the row request of the third row req_y[2] to 1 on the row line 3 to which is coupled said pixel circuit 1. It shall be noted that the time T1 does not correspond to a rising edge or a falling edge of the clock signal clk, because change detection and the row request req_y are event-driven and thus are not synchronous with the clock signal clk.

In the row selector 2 of the readout circuit 14, an input logic circuit 22 to which are coupled the row lines 3 senses that a row request req_y is activated on at least one row line 3 and consequently activates a row request indicator req_y_or. The activated state of the row request indicator req_y_or indicates that at least one row line 3 has a row request req_y which is activated and is sensed by the state machine 24. As visible on **Fig. 5,** the row request indicator req_y_or is set to 1 at time T1, simultaneously with the activation of the row request req_y[2] of the third row.

Shortly after the first instant T1, an illumination change is detected by a pixel of the second row, and said pixel circuit 1 sets the row request of the second row req_y[1] to 1. Even though the input logic circuit 22 detects the activation of the second row request req_y[1], the row request indicator req_y_or is not changed, being already activated in a high state (i.e. at 1).

In addition to the activation of a row request indicator req_y_or, the input logic circuit 22 may activate a derived row request signal req_y_d[n] for each corresponding activated row request req_y[n], the row request signals req_y_d[n] being communicated to an interface circuit 26. The activation of a row request signal req_y_d[n] in response to a corresponding row request signal req_y[n] is conditioned by the empty arbiter signal arb_empty being activated (i.e. arb_empty=1). More specifically, the states of all the row request, activated or deactivated, is reflected as long as the empty arbiter signal arb_empty is activated. During a readout cycle, newly activated row requests are not sampled into activated sampled row requests, due to an empty arbiter signal indicating that the arbiter tree is not empty. As illustrated on **Fig. 5,** the derived row request signal req_y_d[2] of the third row request req_y[2] and the derived row request signal req_y_d[1] of the second row request req_y[1] are activated at the same time as their respective row request req_y[2] and req_y[1]. The derived row request signals req_y_d[0:N-1] allows to select the row requests to be processed during the readout cycle. Should a new row request appear, for example req_y[0] after empty arbiter signal arb_empty being activated, the readout cycle would not be affected.

At an instant T2, in synchronicity with the clock signal clk (more precisely at a rising edge of the clock signal clk), the state machine 24 of the readout circuit 14, in response to the activated state of the row request indicator req_y_or, transitions from the idle state S0 to a first state S1, and activates a sampling request clk_req to the interface circuit 26. The sampling request clk_req is synchronous with the clock signal clk, i.e. with a rising or falling edge of said clock signal clk, in order to allow a proper processing by the components of the readout circuit.

Preferably, as the asynchronous row request indicator req_y_or should be synchronized with the state machine clock to avoid metastable states, it is possible to have one clock cycle delay between the activation of the row request indicator req_y_or and the activation of the sampling request clk_req by the state machine 24. This is the case in **Fig. 5,** in which the sampling request clk_req is activated at the second rising edge of the clock signal clk after the activation of the row request indicator req_y_or, i.e. at instant T2, instead of being activated at the first rising edge after instant T1.

As described, the activation of the sampling request may be fully conditioned by the reception of the row request indicator req_y_or, and therefore be generated at a following instant of the clock signal clk. This approach could be defined as a fully event-driven mode, in which only requesting rows/pixel circuit 1 are read out or acknowledged on-demand in a defined order whenever a pixel circuit 1detected a change in illumination in its field of view. This event-driven approach guarantees a minimum time between the detection of the illumination change by a pixel circuit 1 and its readout especially for low to medium levels of scene activity. In this approach, the readout timing is not correlated with any external signal such as a framerate.

It is possible to mitigate the independence of the readout from an external signal by conditioning the activation of the sampling request clk_req to an external signal. All row request signals req_y of the pixel array are sampled at the same time with a certain fixed or variable rate by an external signal. This approach could be defined as a global synchronous mode. As for the event-driven mode, only requesting rows/pixel are acknowledged and read out in a defined order. In this global synchronous approach, event data with a certain frame rate is generated which can be beneficial for use with frame-based processing approaches/algorithms.

It is also possible to adapt to standard, frame-based, communication protocols and processing approaches that are not able to store complete frames, by sampling row request signals req_y of the array by an external signal sequentially row-by-row in a defined order with a certain fixed row- and frame-rate, once again by conditioning the sampling request clk_req to an external signal. If there are active pixel circuits 1 (i.e. with an activated row request req_y) in the row, they are read out and acknowledged, otherwise the readout circuit waits depending on the row-rate until the next row is accessed. This approach could be defined as the rolling synchronous mode. This method can guarantee a constant flow of data. Preferably, in order to benefit from the sparse nature of the illumination events most of the time, it is possible to use an external signal defining a frame rate which is faster that the time required to read out all the pixels, as most of them usually do not need to be read out. This allows achieving a frame-rate which is significantly faster than a conventional image sensor.

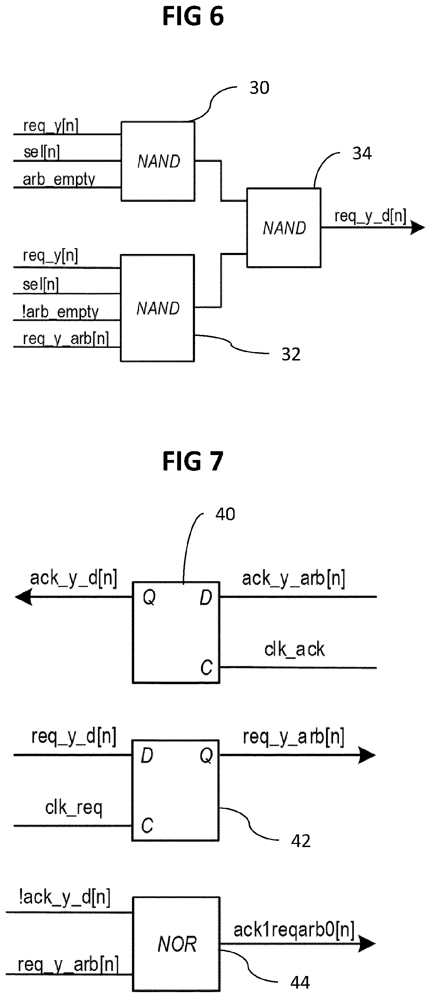

The interface 26, in response to the activation of the sampling request clk_req by the state machine 24, samples the row requests req_y[0:N-1] of all the rows (i.e. a row request req_y[n] for each row n) into sampled row requests req_y_arb [0:N-1]. As illustrated, the row requests which are sampled can be derived row requests req_y_d[0:N-1] provided to the interface 26 from the input logic circuit 22, which are the same as the row requests req_y_[0:N-1] as long as the empty arbiter signal arb_empty is activated. In the example of **Fig. 5,** at the instant T2, the interface 26 samples the derived row requests req_y_d of the three rows: req_y_d[0]=0, req_y_d[1]=1, req_y_d[2]=1. In the exemplary circuit of the interface 26 at row level of Fig. 7, a memory element 42 such as a D-flip-flops receives the row requests req_y[n] of the row n, which is, by the sampling request clk_req, sampled into the sampled row requests req_y_arb[n].

The N sampled row requests req_y_arb [0:N-1] of all the rows are available to the arbiter tree 28 of the readout circuit 1. The readout circuit 1, through the arbiter tree 28 determines which row is to be selected among the rows with an unacknowledged sampled row request req_y_arb [0:N-1] based on a predetermined rule. The rows are associated with a row order, which means that a position in a row order is associated with each row. Hence, each row can be identified, and positioned with respect to the other in the row order. Typically, the row order simply consists in having the row numbered sequentially from top to bottom of the array (e.g. 1$^{st}$ row above the 2$^{nd}$ row which is above the 3$^{rd}$ row, etc.), or conversely from bottom to top of the array (e.g. 1$^{st}$ row below the 2$^{nd}$ row which is below the 3$^{rd}$ row, etc.). Other types of row order would be chosen. The row order is browsed in accordance with the predetermined rule, based on respective positions of the rows with sampled activated row requests in the row order.

The activated sampled row requests req_y_arb are selected sequentially by the arbiter tree 28, and in each row with a selected sampled activated row request ack_y_arb, each pixel circuit with an activated row request is read and reset before another row with a sampled activated row request is selected, until all the sampled activated row requests req_y_arb have been selected. The predetermined rule is for example an ascending order (i.e. 0, 1, 2, etc.) or a descending order (i.e. N, N-1, N-2, etc.) for browsing the row order, or could be another rule for browsing the row order. For example, a rule with non-successive rows in the row order can be used. The rows may also be organized into groups which are successively browsed. For example, a first set of non-successive rows can be browsed before a second set of non-successive rows is browsed. For instance, an interleaved sequence could be used, where rows with even numbers (e.g. 0, 2, 4, 6, etc.) are considered before rows with odd numbers (e.g. 1, 3, 5, 7, etc.) are considered, or conversely. Such an interleaved sequence would allow to trade off the temporal precision vs. the spatial precision of the field of view of the sensor.

Preferably, the sequence in which the activated sampled row requests are selected is independent of a temporal order in which row requests were activated. Preferably, the same predetermined rule is used in each readout cycle, but it could be changed between two readout cycles. The predetermined rule is stored in the arbiter tree 28 as the rule on which is based the selection of the row to be processed. The rule may be stored as a selection order of rows, i.e. a list of rows designated by their positions in the row order and organized in accordance with the predetermined rule.

Preferably, the rule organizes the browsing of the whole row order. In other words, if all rows have a sampled activated row request, the application of the rule would result in the organizer 28 selecting all the rows one after the other.

In the depicted example, sampled row request signals are designated as req_y_arb since they are arbiter inputs, but they carry the same information or state as the derived row requests req_y_d[0:N-1], i.e. the states of the row requests req_y [0:N-1] before deactivation of the empty arbiter signal arb_empty. The arbiter tree 28 selects one row n among the rows 0 to N-1 for which the sampled row request req_y[0:N-1] is activated (i.e. req_y_arb[n]=1), based on the predetermined order. The arbiter tree 28 activates the acknowledged row request ack_y_arb[n] of the selected row n (ack_y_arb[n]=1), and keeps deactivated the acknowledged row requests ack_y_arb (ack_y_arb[i≠n]=0) for the N-1 rows other than the selected row n.

In the example of **Fig. 5,** at the instant T2, the arbiter tree 28, must select one row among the second and third rows since their respective sampled row request req_y_arb[1;2] are activated. The first sampled row request req_y_arb[0] is not activated (i.e. req_y_arb[0]=0) and therefore the first row cannot be chosen. In this non-limiting example, the arbiter tree 28 selects a row based on an ascending order, which means that the second row is selected before the third row, even though the second row request req_y[1] was activated slightly after the third row request req_y[2]. As a consequence, the arbiter tree 28 activates the acknowledged row request ack_y_arb[1] (ack_y_arb[1]=1) for the second row, and keep deactivated the acknowledged row requests ack_y_arb[0] (ack_y_arb[0]=0) of the first row and the acknowledged row requests ack_y_arb[2] (ack_y_arb[2]=0) of the third row, to indicate that the corresponding rows are not selected at this time.

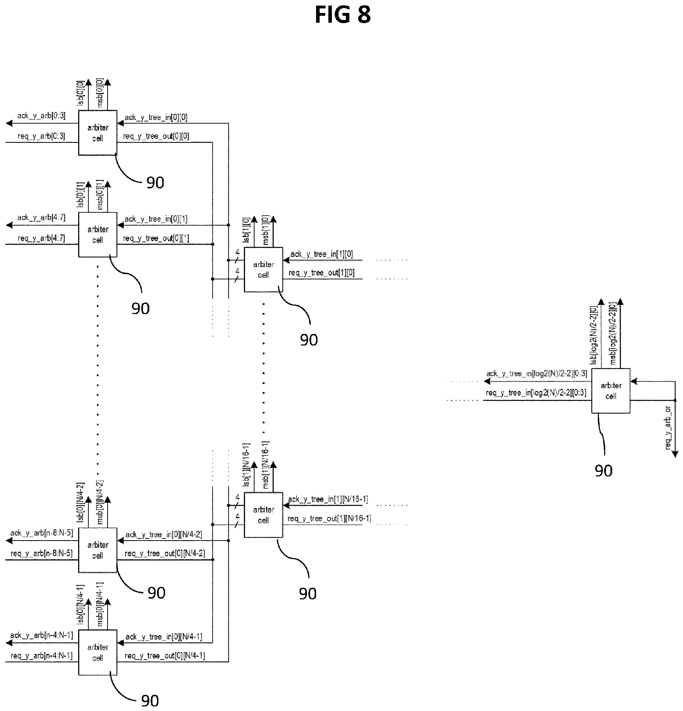

**Fig. 8** shows a simplified schematic diagram of an example of an arbiter tree 28 for row selection. In this non-limiting example, the arbiter tree 28 comprises 4:1 arbiter cells, i.e. multiplexing four rows. It is also possible not to multiplex, or to have another multiplexing factor. The arbiter cells are organized in levels, higher levels being connected to lower levels. Outcoming tree row request req_y_tree_out req_y_tree_out and outcoming multiplexed acknowledge request ack_y_tree_out are the connections to the next level in the arbiter tree 28. A sampled row request req_y_arb is propagated through the arbiter tree 28 to the top and the resulting acknowledge signal is communicated back to the root of the arbiter tree 28 as an acknowledged row request ack_y_arb. Furthermore, in every stage the input signals (lsb, msb) of the y address encoder are generated. The output of the last arbiter cell is additionally used as an indicator whether the arbiter is empty (req_y_arb_or=0) or not (req_y_arb_or=1).

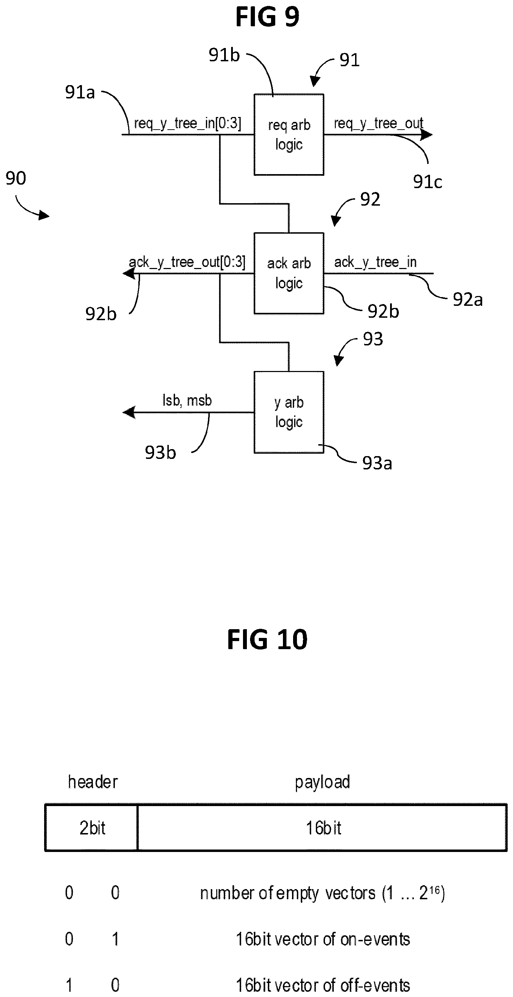

**Fig. 9** shows a possible embodiment of a circuit 90 of an 4:1 arbiter cell in the arbiter tree 28 of **Fig. 8** with four request inputs and four acknowledge outputs which are multiplexed. In the depicted example, the rows are the first four rows numbered 0 to 3, but of course other row numbers could be processed. The circuit 90 comprises a request path 91, an acknowledge path 92, and an address path 93 to generate the input signals for the y address encoder generating the y_address signal.

In the request path 91, a req arb logic circuit 91b receives on a input 91a the incoming multiplexed tree row request req_y_tree_in[0:3] and outputs on an output 91c the outcoming tree row request req_y_tree_out towards an higher level in the arbiter tree 28. Preferably, the req arb logic circuit 91b performs a logical "or" function on the incoming multiplexed tree row request req_y_tree_in[0:3], which means that the outcoming tree row request req_y_tree_out has to be activates (i.e.1) if one of the incoming multiplexed tree row request req_y_tree_in[0:3] is activated (i.e. 1) to propagate the input signal to the higher level in the arbiter tree 28. For example, a possible logical function to realize this functionality can be:

*req_y_tree_out=req_y_tree_in[3] v req_y_tree_in[2] v req_y_tree_in[1] v req_y_tree_in[0].*

with "v" denoting the "or" function.

In the acknowledge path 92, an ack arb logic circuit 92b receives on an input 92a the incoming tree acknowledge request ack_y_tree_in from a higher level and outputs on an output 92b the outcoming multiplexed acknowledge request ack_y_tree_out[0:3] towards a lower level in the arbiter tree 28. The outcoming multiplexed acknowledge request ack_y_tree_out[0:3] must be activated (i.e. 1) to transmit the corresponding acknowledge signal to the lower stages in the arbiter tree 28. Therefore, the outcoming multiplexed acknowledge request ack_y_tree_out[n] has to be activated only for the first signal n in the bus of req_y_tree_in[0:n:3] which is activated if the incoming tree acknowledge request ack_y_tree is activated (i.e. 1). The input 91a in the row request path 91a is connected to the ack arb logic 92b to provide the incoming multiplexed tree row request req_y_tree_in[n]. For example, possible logical functions to realize this functionality can be:

$$ack\_y\_tree\_out[0] = req\_y\_tree\_in[0] \,\hat{}\, ack\_y\_tree\_in$$

$$ack\_y\_tree\_out[1] = (req\_y\_tree\_in[1] \,\hat{}\, ack\_y\_tree\_in) \,\hat{}\, !req\_y\_tree\_in[0]$$

$$ack\_y\_tree\_out[2]=(req\_y\_tree\_in[2]\char`^ack\_y\_tree\_in)\char`^!req\_y\_tree\_in[1]\char`^ \ !req\_y\_tree\_in[0]$$

$$ack\_y\_tree \ out[3]=(req\_y\_tree\_in[3]\char`^ack\_y\_tree\_in)\char`^ \ !req\_y\_tree\_in[2] \ \char`^ \ !req\_y\_tree\_in[1] \ \char`^ \ !req\_y\_tree\_in[0]$$

with ^ denoting the AND function and ! the logical negation.

The input signals (lsb, msb) of the y address encoder are generated by the y arb logic 93a and issued on an output 93b. The inputs signal lsb, msb for the y address encoder are for example generated by:

$$lsb = !ack\_y\_tree\_out[1] \ \char`^ \ !ack\_y\_tree\_out[0]$$

$$msb = !ack\_y\_tree\_out[3] \ \char`^ \ !ack\_y\_tree\_out[2]$$

The y-encoder generates a digital word of the width log2(N) that encodes the address of the row which is selected for acknowledgement. Every bit n of the address is composed by an OR-connection of the corresponding arbiter cell output signals lsb[n] or msb[n] of all rows:

-

$$y\_address[0]=OR(lsb[0][0:N/4-1])$$

-

$$y\_address[1]=OR(msb[0][0:N/4-1]))$$

-

$$y\_address[2]=OR(lsb[1][0:N/16-1])), \ etc.$$

Since at least one sampled row request is acknowledged by the arbiter tree 28, the arbiter tree 28 activates the arbiter indicator req_arb_or (i.e. req_arb_or=1) to indicate that the arbiter tree 28 is sensing at least one activated sampled row request req_y_arb[n].

Simultaneously with the selection of the row to be read, the arbiter tree 28 encodes the address of the selected row, i.e. the one for which the acknowledged row request ack_y_arb[n] is activated, and transmits the encoded address in an address signal y_address[0; ceil(log2(N))-1], as explained above. In this example, the address is expressed in binary numbers, hence the length of log2(N) of the address. In the example of **Fig. 5** in which the second row is selected among three rows, the address signal y_address is the coding address d1 for the second row, and is for example 0001. Other encodings can be used. The address signal y_address is sent to an event-data-formatter 6 in charge for forming packets and sending them to the bus. Typically, the address signal y_address is encoded into the header of a packet containing a vector of the events read from the row.

In the next step, at time T3, in response to the arbiter indicator req_arb_or being activated and in synchronism with a clock signal clk to synchronize this step with the clock signal, the state machine 24 transitions in from the first state S1 to a second state S2 and activates the clock acknowledgement clk_ack (i.e. clk_ack =1 on **Fig. 5**) to cause the processing of the acknowledged row requests ack_y_arb by the interface 26. In response to the clock acknowledgement clk_ack, the interface 26 samples all the acknowledged row requests ack_y_arb. The acknowledged row requests ack_y_arb are applied as acknowledged row signal ack_y to the sensor array. In the example, the acknowledged row signal ack_y[1] for the second row is activated because the second row is the selected row, whereas the acknowledged row signals ack_y [0;2] of the other rows stay deactivated. More precisely, as shown in **Fig. 7,** in an example of embodiment of a circuit of an interface 26 a row level, the selected acknowledged row request ack_y_arb[n] is sampled by the clock acknowledgement clk_ack in a memory element 40 such as a D-flip-flop. As a result, the output of the memory element is the acknowledged row signal ack_y[n] sent to the sensor array. The sampled acknowledged row signal ack_y_d[n] is similar to the acknowledged row signal ack_y[n], but it referred to as acknowledged row signal ack_y_d[n] for example in Fig. 7 to indicate that it is sampled through the clock acknowledgement signal clk_ack. For the sake of simplification, the sampled acknowledged row signal ack_y_d[n] can be referred to as the acknowledged row signal ack_y_d[n].

The state machine 24 also activates a row validity signal row_valid is activated (i.e. row_valid=1) to indicate that the address signal y_address is valid. In response to the arbiter indicator req_arb_or being activated, the state machine 24 also deactivates the empty arbiter signal arb_empty (i.e. arb_empty=0) to indicate that the arbiter 28 is no longer empty.

The empty arbiter signal arb_empty is sensed by the input logic 22. Due to the empty arbiter signal arb_empty being deactivated, the input logic 22 no longer translates incoming new row requests req_y[n] into derived row requests req_y_d[n] that could be processed in this readout cycle.

Fig. 6 shows a schematic example of the circuit at a row level of the input logic 22. There are as many such circuits as there are rows in the pixel array. The input logic 22 activates or deactivates the derived row requests req_y_d[n], or keeps the derived row requests req_y_d[n] depending on the row request req_y[n], the status of the arbiter 28 indicated by the empty arbiter signal arb_empty, and the row status indicated by sampled row requests req_y_arb[n] from the interface 26. The selection signal sel[n] is used to unselect specific lines (sel[n]=0) which are not read out. In addition, the derived row request signals req_y_d[0:N-1] of all rows are OR-connected to generate the row request indicator req_y_or on block level.

A first NAND gate 30 receives the row request req_y[n] of the row, the selection signal sel[n] for the row, and the empty arbiter signal arb_empty. The fist NAND gate 30 serves to activate the derived row requests req_y_d[n] as described above. Once the empty arbiter signal arb_empty is deactivated, the fist NAND gate 30 no longer activates the corresponding derived row request req_y_d[n]. A second NAND gate 32 receives the row request req_y[n] of the row, the selection signal sel[n] for the row, the negation of the empty arbiter signal arb_empty, and the sampled row request req_y_arb[n] for the row. The second NAND gate 32 serves to keep the state of the derived row requests req_y_d[n] after the empty arbiter signal arb_empty is deactivated. The outputs of the first NAND gate 30 and the second NAND gate 32 are inputs to a third NAND gate 34 which outputs the derived row requests req_y_d[n] for the row.

In response to the acknowledged row signal ack_y[n], all the pixel circuits 1 in the selected row (i.e. row 2 in this example) which are active (i.e. with a row request which is not acknowledged yet) send a data request, or column request req_x. Preferably, there are two kinds of column requests: an ON column request req_x_on for indicating a positive illumination change (i.e. an increase), and an OFF column request req_x_off to indicate a negative illumination change (i.e. a decrease). For example, a pixel circuit 1 which experienced a positive illumination change will activate an ON column request req_x_on (i.e. req_x_on=1) whereas a pixel circuit 1 which experienced a negative illumination change will activate an OFF column request req_x_off (i.e. req_x_off=1). It is possible to have the two kinds of column requests for the same pixel circuit 1 if the pixel circuit 1 experienced both an increase and a decrease in illumination since the last sampling. The column interface 4 samples the column request req_x[M] of the M columns, originating from the selected row n. The column requests sampled by the column interface 4 are then sent to the event-data-formatted where the column requests are associated with the corresponding row address, for example in a packet.

As a pixel circuit 1 is read, it is also reset, which means that the column request req_x are deactivated (req_x_on=0 and/or req_x_off=0), and the row request is released (req_y[n]=0). It shall be noted that the readout and consequently the release of the row request req_y[n] is asynchronous and may take longer than one clock cycle of the clock signal clk, and may be different for different rows of pixels. In the example of Fig. 5, reading the second row is longer than reading the third row, and the release of the row request req_y[1] of the second row takes around 2.25 clock cycles whereas the release of the row request req_y[2] of the third row takes around 0.75 clock cycles.

After having sampled the column request req_x[M] and once it is ready to read the next selected row, the column interface 4 confirms that the circuit pixels 1 of the selected row n has been read by activating the read confirmation send_ack_y (i.e. send_ack_y=1) for a given duration, here during one clock cycle. At time T4, the activated send_ack_y causes the state machine 24 to transition from the second state S2 to a third state S3. By doing so, the state machine 24 issues a sampling request clk_req and deactivates the row validity signal row_valid (i.e. row_valid=0) to indicate that no new row address y_address is provided.

The row request req_y[1] of the second row is then released, following the resetting of pixel circuits 1 in said second row. It is to be noted that the deactivation of the row request req_y[n] depends on the time required by the column interface 4 to read the pixel circuit, and is preferably not conditioned by any clock signal clk, but is asynchronous. In the example of **Fig. 5,** the deactivation of the row request req_y[1] of the second row occurs between the rising edge of the clock signal clk at time T4 and the next rising edge of the clock signal clk. Simultaneously, the derived row request req_y_d[1] of the second row returns to the deactivated state (i.e. req_y_d[1]=0).

In the third state S3, the state machine 24 periodically generates a sampling request clk_req, preferably at each clock signal clk. The sampling request clk_req is received by the interface 26, which samples the row requests req_y[0:N-1] of all the into sampled row requests req_y_arb [0:N-1] to update the sampled row requests req_y_arb[0:N-1], in order to detect a release of a previously held row requests req_y[n]. Indeed, after the readout of the selected row is finished, the row request req_y[n] of the selected row being now deactivated, the sampled row request req_y_arb[n] of the selected row sent by the interface 26 to the arbiter 28 is now deactivated. The other sampled row request req_y_arb are however unaltered. In the example of **Fig. 5,** the row request req_y[1] of the second row being at 0 causes the sampled row request req_y_arb[1] for the second row to go to 0, but the row request req_y[2] of the third row stays at 1.

The interface 26 comprises a combinational logic block that indicates the situation that the sampled row request req_y_arb[n] is already deactivated while the sampled acknowledged row signal ack_y_d[n] is still activated during the request-acknowledge cycle before releasing the acknowledged row signal ack_y[n]. In the exemplary circuit of the interface 26 at row level of Fig. 7, a NOR gate 44 receives as inputs the negation of the sampled acknowledged row signal ack_y_d[n] and the sampled row request req_y_arb[n], and outputs a row discrepancy indicator ack1reqarb0[n] for that row. The signals ack1reqarb0[0:N-1] of all rows are OR-connected to generate the discrepancy indicator signal ack1reqarb0_or on array level. In our example, row discrepancy indicator ack1reqarb0[1] of the second row becomes activated, and consequently the discrepancy indicator ack1reqarb0_or becomes activated (i.e. ack1reqarb0_or=1). The state machine 24 stays in the third state S3 as long as the discrepancy indicator ack1reqarb0_or stays activated.

Since the sampled row request req_y_arb [n] of the selected row sent by the interface 26 to the arbiter 28 is now deactivated, the arbiter 28 deactivates the acknowledged row request ack_y_arb[n] of the previously selected row, and checks whether there is still a sampled row request req_y_arb[n] which is not yet acknowledged. If one there is still at least one sampled row request req_y_arb activated on the interface 26, a next active row line is selected by the arbiter 28 tree, based in the predetermined order. For example, the next selected active row line is chosen in ascending order or descending order. The new acknowledged row request ack_y_arb[n] is activated. In the example of **Fig. 5,** the acknowledged row request ack_y_arb[1] of the second row is deactivated (i.e. ack_y_arb[1]=0). Since the sampled row request req_y_arb[2] of the third row is still activated and is next in the predetermined order, the acknowledged row request ack_y_arb[2] of the third row is activated (i.e. ack_y_arb[2]=1).

As previously described, simultaneously with the selection of the row, the arbiter tree 28 encodes the address of the selected row, i.e. the one for which the acknowledged row request ack_y_arb[n] is activated, and transmits the encoded address in an address signal y_address[0; ceil(log2(N))-1]. In the example of Fig. 5 in which the third row is now selected, the address signal y_address becomes the coding address d2 for the third row.

Next, at time T5, the discrepancy indicator ack1reqarb0_or being activated and the arbiter indicator req_arb_or being still activated (i.e. req_arb_or=1) cause the state machine 24 to transition from the third state S3 to the second state S2. The state machine 24 activates the clock acknowledgement clk_ack (i.e. clk_ack =1) which is used as a sampling signal, in response to the state machine 24 sensing that the presence of unprocessed row requests due to the arbiter indicator req_arb_or.

Upon sensing the activation of the clock acknowledgement clk_ack, the interface 26 samples all the acknowledged row requests ack_y_arb. The acknowledged row requests ack_y_arb are applied as acknowledged row signal ack_y to the sensor array. The change of selected row is thus confirmed in the acknowledged row signal ack_y. The acknowledged row signal ack_y is released by the previous selected row, and is assigned to the newly selected row. In the example of **Fig. 5,** only the acknowledged row requests ack_y_arb[2] of the third row is acknowledged at time T5 (ack_y_arb[2]=1) while the other rows have unacknowledged row requests (ack_y_arb[0]=0, ack_y_arb[0]=1). Consequently, the acknowledged row signal ack_y[1] of the second row is deactivated while the acknowledged row signal ack_y [2] of the third row becomes activated.

The row validity signal row_valid is also activated (i.e. row_valid=1) by the state machine 24 to indicate that the address signal y_address is valid. Because the activated state of the acknowledged row signal ack_y[n] of the newly selected row now matches the activated state of the sampled row request req_y_arb[n] for the same the newly selected row, the interface 26 deactivates the discrepancy indicator ack1reqarb0_or (i.e. ack1reqarb0_or =0).

As explained above, in response to the acknowledged row signal ack_y[n], all the pixel circuits 1 in the selected row (i.e. row n) which are active (i.e. with a row request which is not acknowledged yet) send a data request, or column request req_x, such as an ON column request req_x_on and/or an OFF column request req_x_off. The column interface 4 samples the column request req_x[M] of the M columns, originating from the selected row n. In the course of the readout of a pixel circuit 1, the row request req_y of said pixel circuit is reset. After each active pixel circuit 1 of the selected row line 3 has been read, the row request req_y[n] of the row line 3 goes to 0, and consequently the derived row request req_y_d[n] also.

In the example of **Fig. 5,** after all the active pixel circuits 1 of the third row have been read, the row request req_y[2] of said third row is deactivated (i.e. req_y[2]=0). The row request req_y is released by the third row once it has been read. As explained before, the timing of such operations depends on the readout, and may be asynchronous with respect to the clock signal. Simultaneously, the derived row request req_y_d[2] returns to the deactivated state (i.e. req_y_d[2]=0).

As a consequence of the release of the row request req_y[2] of the third row, none of the three row lines 3 has any row request req_y left activated, and the row request indicator req_y_or returns to a deactivated state (req_y_or=0). Of course, should any row request req_y[N] be still activated, the row request indicator req_y_or would still be activated and the row requests req_y of another row would be processed, as explained above.

After having sampled the column request req_x[M] and once it is ready to read the next selected row, the column interface 4 confirms that the circuit pixels 1 of the selected row n has been read by activating the read confirmation send_ack_y (i.e. send_ack_y=1) for a given duration, here during one clock cycle.

At time T6, the activated send_ack_y causes the state machine 24 to transition from the second state S2 to the third state S3. By doing so, the state machine 24 issues a sampling request clk_req and deactivates the row validity signal row_valid (i.e. row_valid=0) to indicate that no new row address y_address is provided. Optionally, the row address signal y_address may go back to a default address such as d0 in the example of **Fig. 5.**

In response to the sampling request signal clk_req, the interface 26 causes the sampling of the derived row requests req_y_d[N] into the sampled row requests req_y_arb[N] by the interface 26. The activation status of the derived row requests req_y_d[N] are transferred to the sampled row requests req_y_arb[N]. In the example of **Fig. 5,** the derived row request req_y_d[2] of the third row has already returned to the deactivated state, and the sampled row request req_y_arb[2] of the third row sent by the interface 26 to the arbiter 28 becomes deactivated, i.e. goes to 0.

Because the acknowledged row signal ack_y[2] of the third row is still activated while the sampled row request req_y_arb[2] of the same selected row is deactivated, the discrepancy indicator ack1reqarb0_or is activated by the interface 26 to indicate to the state machine 24 that the acknowledged row signal ack_y[n] is held by a row without an active sampled row request req_y_arb[n].

The arbiter 28 deactivates the acknowledged row request ack_y_arb[n] of the previously selected row, and checks whether there is still a sampled row request req_y_arb[n] which is not yet acknowledged. If there is one, the process goes back to the operations as in previously described. If there is none, no new sensor array row will be selected by the arbiter 28. In the example of **Fig. 5,** the acknowledged row request ack_y_arb[2] of the third row is deactivated, and there is no other sampled row request req_y_arb[n] which is not yet acknowledged (all the sampled row request req_y_arb[N] are deactivated. In this case, the arbiter tree 28 deactivates the arbiter indicator req_arb_or (i.e. req_arb_or=0) to indicate that the arbiter tree 28 is now empty.

The discrepancy indicator ack1reqarb0_or is activated (ack1reqarb0_or=1) and the arbiter indicator req_arb_or is deactivated (req_arb_or=0), which shows that all the row requests involved in the readout processing have been processed. In the present example, there is no longer any activated row request, as shown by the row request indicator req_y_or being deactivated (i.e. req_y_or=0). The state machine 24 therefore transitions from the third state S3 to the idle state S0, waiting for new row requests to appear in order to start a new readout cycle. The state machine 24 activates a clock acknowledgement clk_ack (clk_ack=1) and the empty arbiter signal arb_empty (i.e. arb_empty=1) to indicate that the arbiter 28 is empty and that new incoming row requests could be processed.

If there had been activated row requests waiting to be processed in a new cycle, the row request indicator req_y_or would be activated (i.e. req_y_or=1), and the state machine would transition from the third state S3 to the first state S1. In addition to the activation of the clock acknowledgement clk_ack (clk_ack=1) and the empty arbiter signal arb_empty (i.e. arb_empty=1), the state machine 24 would issue a sampling request clk_req to cause the sampling of the row request req_y[N] to be processed. A new readout cycle would start.

It shall be noted that if the state machine 24 is in the first state S1, and despite a previous sampling request clk_req, the arbiter tree 28 senses no activated sampled row request req_y_arb[n] and thus the arbiter indicator req_arb_or is deactivated (i.e. req_arb_or=0), the state machine 24 would transition to the idle state S0 and would deactivate the empty arbiter signal arb_empty (i.e. arb_empty=0). This ensures that the row selector is not blocked, for example in a case where there is only one activated row request req_y[n] and it is removed before it is sampled.

The activation of the clock acknowledgement clk_ack (clk_ack=1) causes the interface 26 to sample the acknowledged row requests ack_y_arb[n] and to output the derived acknowledged row signal ack_y[n]. In the example of **Fig. 5,** the sampled acknowledged row signal ack_y[2] of the third row thus goes back to a deactivated state (i.e. ack_y[2] =0). Because the states of the acknowledged row signals ack_y[n] now match the state of the sampled row request req_y_arb[n], the interface 26 deactivates the discrepancy indicator ack1reqarb0_or (i.e. ack1reqarb0_or =0).

As explained earlier, it is possible to mitigate the independence of the readout from an external signal by conditioning the activation of the sampling request clk_req to an external signal. All row request signals req_y of the pixel array are sampled at the same time with a certain fixed or variable rate by an external signal. This approach could be defined as a global synchronous mode. It is also possible to adapt to standard, frame-based, communication protocols and processing approaches that are not able to store complete frames, by sampling row request signals req_y of the array by an external signal sequentially row-by-row in a defined order with a certain fixed row- and frame-rate, once again by conditioning the sampling request clk_req to an external signal. If there are active pixel circuits 1 (i.e. with an activated row request req_y) in the row, they are read out and acknowledged, otherwise the readout circuit waits depending on the row-rate until the next row is accessed. This approach could be defined as the rolling synchronous mode.

The usage of an external trigger signal in the global synchronous mode as well as in the rolling synchronous mode allows the generation of binary frames in a straightforward way. A frame is a description of the state of each pixel circuit in the pixel array at the same time. The binary frames are similar to frames in standard image sensors containing one of four possible values per pixel: no event, high polarity event or on-event (positive contrast), low polarity event or off-event (negative contrast), or on-event and off-event (both contrasts). In a binary encoding scheme this requires 2 bits per pixel circuit 1. In the global synchronous mode, the same time-stamp is assigned to all pixels in a frame as they are sampled at the same time while in the rolling synchronous operation mode, all pixels in a row have the same time-stamp. The value of time-stamp can be (externally) derived from the frame-rate (and row-rate). The instantaneous frame-rate can be inherently transferred using available frame-rate encoding mechanisms of established data transmission approaches, e.g. the blanking signal in the Mobile Industry Processor Interface, MIPI, protocol.

Especially in the global synchronous operation mode with a high sampling rate for low to mid-range scene activity the binary frame contains only a few events while still 2 bits per pixel circuit 1 need to be transmitted. This either requires a permanently high transmission bandwidth (and power consumption) or limits the maximal possible frame-rate.

A solution to cope with this problem is a frame representation using a compressed event packet data format which allows encoding on the fly during the readout of the sensor array. The readout circuit 14 comprises an event-data-formatter 6 configured to receive the states of the pixel circuits 1 and the addresses of pixel circuits 1 (i.e. address signal y_address) with an active event. The event-data-formatter 6 forms the data words of the frame packet and send them to the bus.

A frame packet (i.e. an entire image) in the compressed event packet data format consists of a series of data words describing the state of each pixel circuit 1 in the sensor array. A state of a pixel circuit 1 can be an empty state when the pixel circuit 1 generated no active event, not having detected an illumination change, or a state in which an active event was generated or activated, if the pixel circuits detected an illumination change. In the operating method described above, the states of the pixel circuits 1 are directly given by the data requests, or column requests req_x retrieved by the column interface 4 when the pixel circuits 1 are read, and provided to the event-data-formatter 6.

In the compressed event packet data format, the frame packet comprises a first type of data words quantifying adjacent pixel circuits without an active event, and a second type of data words reflecting occurrences of active events in a group of adjacent pixel circuits. Each data word comprises a header and a payload, payload, the header containing a code depending on the type of data word, i.e. defining the nature of the data in the payload. The payload contains:

- in the first type of data words, a count of adjacent groups of adjacent pixel circuits 1 without an active event, and
- in the second type of data words, a series of bits indicating whether an active event occurred in each pixel circuits 1 of a group of adjacent pixel circuits 1, with a bit arrangement reflecting an arrangement of the pixel circuits 1 in said group of adjacent pixel circuits 1.

More precisely, an event is characterized by a polarity reflecting a direction of the illumination change (increase or decrease), and the second type of data words comprises:

- a first sub-type reflecting occurrences of active events of a first polarity in a group of adjacent pixel circuits, and
- a second sub-type reflecting occurrences of active events of a second polarity in a group of adjacent pixel circuits.

For example, the first polarity is an increase in illumination, i.e. for an ON-event, whereas the second polarity is a decrease in illumination, i.e. for an OFF-event.

The groups of adjacent pixel circuits 1 are subdivisions of equal size of the rows of the pixel array. For instance, for an array with rows of 1280 pixel circuits 1, a group of adjacent pixel circuits 1 can consist in 16 successive pixel circuits 1, resulting in 80 groups per row of pixel circuits 1, or 20 successive pixel circuits 1, resulting in 64 groups per row, or 32 successive pixel circuits 1, resulting in 40 groups per row, etc.

The states of the pixel circuits 1 of a groups of adjacent pixel circuits 1 form a vector of bits. The vector contains the same number of bits as a group of pixel circuits, each bit describing a state of a corresponding pixel circuit 1 with the same arrangement: the first bit corresponds to the first pixel circuit 1 of the group of adjacent pixel circuits 1, the second bit corresponds to the second pixel circuit 1 of the group of adjacent pixel circuits 1, etc. For instance, for an array with rows of 1280 pixel circuits 1 divided into groups of 16 successive pixel circuits 1, the length of the payload is 16 bits, resulting in 80 vectors per row. If the rows are divided into groups of 20 successive pixel circuits 1, the length of the payload is 20 bits, resulting in 64 vectors per row, etc.

In the first type of data words, the payload contains the number of empty vectors (between vectors containing events). In the second type of data words, the payload contains vectors including ON-events or vectors including OFF-events while in the header the payload data type is encoded. **Fig. 10** shows a possible embodiment of a compressed event packet data format using a 18-bit data word comprising a 2-bit header and a 16-bit payload.

In this example, a first code (e.g. 00) in the header indicates that the payload contains the number of empty vectors, thus belonging to the first type of data words. The number of empty vectors is for example binarily encoded, and can range from 1 to $2^{16}$ empty vectors. A second code (e.g. 01) in the header indicates that the payload contains a vector of ON-events, thus belonging to the first sub-type of the second type of data words. A third code (e.g. 10) in the header indicates that the payload contains a vector of OFF-events, thus belonging to the first sub-type of the second type of data words. In this example, a 16-bit payload is used, which means that the active events of 16 pixel circuits 1 of a row can be encoded in the payload. As an encoding example, a bit at "1" at a position i in the $j^{th}$ k-bit vector of a row (i, j, k being natural integers, with k the width of the payload vector) may mean that an event occurred at the $((j-1)*k)+i)^{th}$ pixel circuit 1 in said row. The header indicates whether the detected event is a ON-event or an OFF-event. Typically, "0" denotes the absence of an active event.

Of course, the encoding, or the size of the header or payload may be adapted. Preferably, the length of the payload is chosen so that the length of a row in terms of number of pixel circuits 1 is a multiple of the length of the payload in bits, as explained above. Typically, the size of the groups of pixel circuits 1 and therefore the length of the vectors is a power of two. The size of the groups of pixel circuits 1 and therefore the length of the vectors should not be too high, because it would be similar to processing each row if a huge number of events occur at a same time, while providing a smaller bandwidth reduction if there are few events. Should the size of the groups of pixel circuits 1 and therefore the length of the vectors be too low, the header would become a significant overhead. Preferably, the size of the groups of pixel circuits 1 and therefore the length of the vectors is comprised between 8 and 128, and preferably between 8 and 64.

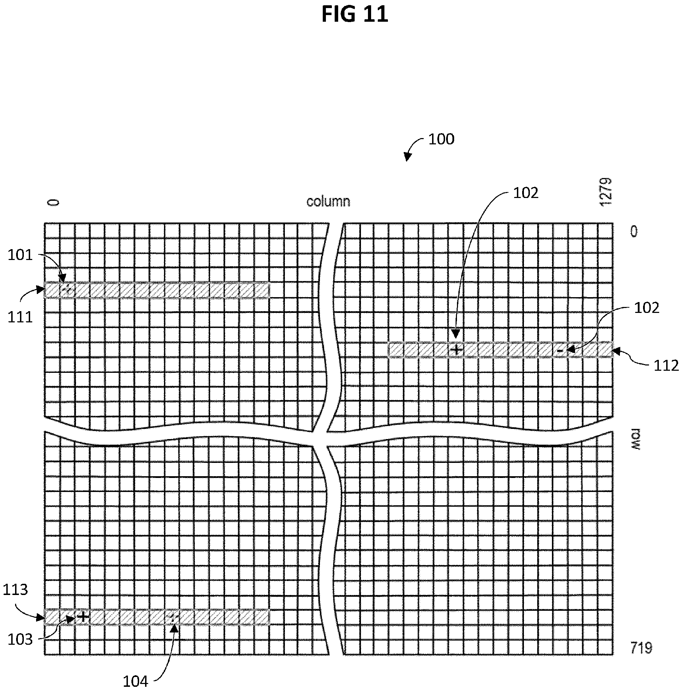

The generation of a compressed frame in the global synchronous operation mode during pixel array readout is explained below using the example of a sensor matrix 100 with 1280 x 720 pixels, with groups of 16 pixel circuits and a readout vector size of 16 pixels (which corresponds to 80 vectors per row) illustrated in **Fig. 11.** In this example, there are five active pixel circuits 1 with an active event (i.e. with an active row request signal req_y):

- four pixel circuits 1 with an ON-event (illustrated by a plus sign): a first pixel circuit 101 at (1,4), a second pixel circuit 102 at (1269,8), a third pixel circuit 103 at (2,717), and a fourth pixel circuit 104 at (8,717);
- one pixel circuit 1 with an OFF-event (illustrated by a minus sign): a fifth pixel circuit 105 at (1276,8).

Since there is a correspondence between groups of pixel circuits 1 and vectors, vectors are used hereinbelow to also refer to the corresponding groups of pixel circuits 1. Some groups of pixel circuits 1 or vectors partitioning the rows are shown with a hatching pattern. During the pixel array readout, the first row which is selected is the $5^{th}$ row (i.e. row number 4) containing an ON-event in the first vector 111 of said $5^{th}$ row, corresponding to the first pixel circuit 101. All the other 1280/16*4= 320 vectors before the first vector 111 of the $5^{th}$ row are empty (e.g. filled with 0 since no events were detected) which can be directly derived from the address signal y_address sent by the organizer such as the arbiter 28. Preferably, at least one data word of the first type in a frame packet is determined from an address of a pixel circuit 1 with an active event, as in this example.

The following vectors in the $5^{th}$ row are empty. This could be detected from the address of the following pixel circuit 1 with an active event. Alternatively, the event-data-formatter 6 may perform a test to detect if no events occurred in a group of adjacent pixel circuits 1 when the event-data-formatter 6 receives the states of each pixel circuits in a group of adjacent pixel circuits. This can be easily detected by applying an OR connection between all column values of a vector during the readout of the row. To this end, the event-data-formatter 6 may contain such an OR connection, typically made of logical gates, to detect the emptiness of a vector. The row request of the $5^{th}$ row is then acknowledged.

The next row to be selected is the $9^{th}$ row (i.e. row 8). In this $9^{th}$ row the last (e.g.) vector 112 contains the second pixel circuit 102 with an ON-event as well as the fifth pixel 102 with an OFF-event. The vector 112 for the ON-event will therefore only contain a "1" at the $5^{th}$ position for the ON-event and the vector 112 for the OFF-event will contain a "1" at the $13^{th}$ position. The other vectors in the $9^{th}$ row are empty.

After the row request of the $9^{th}$ row is acknowledged, the $718^{th}$ row (i.e. row 717) is selected for which the first vector 113 contains two pixels with an ON-event. The first vector 113 for the ON-event will contain a "1" at the $3^{rd}$ position and at the $9^{th}$ position. After the $718^{th}$ row is read out, the organizer recognizes that there is no longer any activated sampled row request, and deactivates the arbiter indicator req_arb. It can thus be determined that the following vectors are empty and that the corresponding number of empty vectors are to be inserted to the end of the frame. A new readout process for the next frame can start.

The data words generated for the described example are:

```
00 0000000101000000 : 320 empty vectors
01 0100000000000000 : vector of ON-events
00 0000000110001110 : 398 empty vectors
01 0000100000000000 : vector of ON-events
10 0000000000001000 : vector of OFF-events
00 1101110101000000 : 56640 empty vectors
01 0010000010000000 : vector of ON-events
00 0000000011101111 : 239 empty vectors
```

Instead of 1280*720*2bit = 1843200 bits using the compressed event packed data format only 144 bits are required to encode the information of an entire frame in this example which is a compression ratio in the order of 10000. For frames capturing higher scene activity this factor is of course reduced, but even in the worst case which is the very unlikely scenario that every vector contains ON-events as well as OFF-events, the overhead due to the data word header would be only 12,5%.

This approach allows to maximize the frame-rate automatically depending on the readout and transmission time of the pixel data. Alternatively, also a fixed frame-rate is possible for sensor operation. In this case the pixel array is read out periodically at defined points in time.

While the present invention has been described with respect to certain preferred embodiments, it is obvious that it is in no way limited thereto. In particular, it will be apparent to those skilled in the art that various changes and modifications may be made without departing from the scope of the invention as defined in the appended claims.

**Claims**

1. A method for operating an event-based image sensor comprising a plurality of pixel circuits (1) arranged in rows and columns to form a pixel array, each pixel circuit (1) being arranged at a location defined by an address, wherein each pixel circuit (1) is configured to detect an illumination change in a photoreceptor signal derived from a photocurrent generated by a light impinging on a light-sensitive element of said pixel circuit (1) and to consequently activate a row request, wherein the pixel array comprises a readout circuit coupled to the pixel circuits by row lines, said readout circuit configured to receive the row request from the pixel circuits and to interact with the pixel circuits to read and reset said pixel circuits,

   wherein during a readout cycle, a plurality of pixel circuits (1) are read and reset on a row-by-row basis by the readout circuit,
   **characterized in that** :

   - at the beginning of the readout cycle, the row requests (req_y) which are activated at said beginning are sampled into activated sampled row requests (req_y_arb),
   - the activated sampled row requests (req_y_arb) are selected by an organizer (28), and in each row with a selected sampled activated row request (ack_y_arb), each pixel circuit with an activated row request is read and reset before another row with a sampled activated row request is selected, until all the sampled activated row requests (req_y_arb) have been selected,

   wherein the rows are associated with a row order, and the organizer (28) selects the sampled activated row requests in a sequence organized by a predetermined rule and based on respective positions of the rows with sampled activated row requests in the row order.

2. The method of claim 1, wherein the sequence in which the activated sampled row requests are selected is independent of an order in which row requests were activated.

3. The method of any one of claims 1 to 2, wherein the predetermined rule organizing the sequence comprises a descending row order or an ascending row order.

4. The method of any one of claims 1 to 3, wherein during a readout cycle, newly activated row requests are not sampled into activated sampled row requests, due to an empty arbiter signal indicating that the organizer is not empty, the organizer being empty when no row request is being processed.

5. The method of any one of claims 1 to 4, wherein the readout circuit comprises an input logic (22) to which are coupled the row lines, and wherein the readout circuit senses a row request (req_y) on at least one row line and sends a row request indicator (req_y_or) to a state machine to indicate that at least one row line has a row request, thereby starting the readout cycle.

6. The method of any one of claims 1 to 5, wherein the readout circuit comprises an input logic (22), and wherein the input logic (22) translates the row requests which are activated at the beginning of the readout into derived row requests, the translation of a row request (req_y) into a derived row request (req_y_d) is conditioned by a selection of the row to which is associated said row request (req_y), through a selection signal,
   and wherein said derived row requests are then sampled into activated sampled row requests..

7. The method of any one of claims 1 to 6, wherein the state machine (24) sends a sampling request (clk_req) to an interface (26), and wherein said interface (26), in response to said row request, samples the row requests on the row lines, said sampling request being synchronous with a clock signal.

8. The method of the preceding claim, wherein the state machine (24) generates the sampling request (clk_req) in response to the row request indicator (req_y_or), or in response to a read confirmation (send_ack_y) that a column interface is ready to read pixel circuits a new row, or periodically during the readout of pixel circuits of a row.

9. The method of any one of the two preceding claims, wherein the state machine (24) generates the sampling request in synchronicity with a frame rate defined by an external signal.

**Patentansprüche**

1. Verfahren zum Betreiben eines ereignisbasierten Bildsensors, umfassend eine Vielzahl von Pixelschaltungen (1), die in Zeilen und Spalten eingerichtet sind, um ein Pixel-Array zu bilden, wobei jede Pixelschaltung (1) an einer Stelle eingerichtet ist, die durch eine Adresse definiert ist, wobei jede Pixelschaltung (1) dazu konfiguriert ist, eine Beleuchtungsveränderung in einem Photorezeptorsignal zu erkennen, das von einem Photostrom abgeleitet ist, der durch ein Licht erzeugt wird, das auf ein lichtempfindliches Element der Pixelschaltung (1) auftrifft, und infolgedessen eine Zeilenanforderung zu aktivieren, wobei das Pixel-Array eine Ausleseschaltung umfasst, die an durch Zeilenleitungen an die Pixelschaltungen gekoppelt ist, wobei die Ausleseschaltung dazu konfiguriert ist, die Zeilenanforderung von den Pixelschaltungen zu empfangen und mit den Pixelschaltungen zu interagieren, um die Pixelschaltungen auszulesen und zurückzusetzen,

   wobei eine Vielzahl von Pixelschaltungen (1) während eines Auslesezyklus auf einer Zeile-für-Zeile-Basis durch die Ausleseschaltung ausgelesen und zurückgesetzt werden,
   **dadurch gekennzeichnet, dass**:

   - zum Beginn des Auslesezyklus die Zeilenanforderungen (req_y), die zum Beginn aktiviert werden, zu aktivierten abgetasteten Zeilenanforderungen (req_y_arb) abgetastet werden,
   - die aktivierten abgetasteten Zeilenanforderungen (req_y_arb) von einem Organisator (28) ausgewählt werden und in jeder Zeile mit einer ausgewählten abgetasteten aktivierten Zeilenanforderung (ack_y_arb) jede Pixelschaltung mit einer aktivierten Zeilenanforderung ausgelesen und zurückgesetzt wird, bevor eine andere Zeile mit einer abgetasteten aktivierten Zeilenanforderung ausgewählt wird, bis alle der abgetasteten aktivierten Zeilenanforderungen (req_y_arb) ausgewählt wurden,

   wobei die Zeilen mit einer Zeilenreihenfolge assoziiert sind und der Organisator (28) die abgetasteten aktivierten Zeilenanforderungen in einer Sequenz, die durch eine vorbestimmte Regel organisiert wird, und auf der Basis von jeweiligen Positionen der Zeilen mit abgetasteten aktivierten Zeilenanforderungen in der Zeilenreihenfolge auswählt.

2. Verfahren nach Anspruch 1, wobei die Sequenz, in der die aktivierten abgetasteten Zeilenanforderungen ausgewählt werden, von einer Reihenfolge, in der Zeilenanforderungen aktiviert wurden, unabhängig ist.

3. Verfahren nach einem der Ansprüche 1 bis 2, wobei die vorbestimmte Regel, die die Sequenz organisiert, eine absteigende Zeilenreihenfolge oder eine aufsteigende Zeilenreihenfolge umfasst.

4. Verfahren nach einem der Ansprüche 1 bis 3, wobei neu aktivierte Zeilenanforderungen während eines Auslesezyklus aufgrund eines leeren Arbiter-Signals, das angibt, dass der Organisator nicht leer ist, nicht zu aktivierten abgetasteten Zeilenanforderungen abgetastet werden, wobei der Organisator leer ist, wenn keine Zeilenanforderung verarbeitet wird.

5. Verfahren nach einem der Ansprüche 1 bis 4, wobei die Ausleseschaltung eine Eingabelogik (22) umfasst, an die die Zeilenleitungen gekoppelt sind, und wobei die Ausleseschaltung eine Zeilenanforderung (req_y) auf mindestens einer Zeilenleitung erfasst und einen Zeilenanforderungsindikator (req_y_or) an eine Zustandsmaschine sendet, um anzugeben, dass mindestens eine Zeilenleitung eine Zeilenanforderung aufweist, wodurch der Auslesezyklus gestartet wird.

6. Verfahren nach einem der Ansprüche 1 bis 5, wobei die Ausleseschaltung eine Eingabelogik (22) umfasst, und wobei die Eingabelogik (22) die Zeilenanforderungen, die zum Beginn des Auslesens aktiviert werden, in abgeleitete Zeilenanforderungen übersetzt, wobei die Übersetzung einer Zeilenanforderung (req_y) in eine abgeleitete Zeilenanforderung (req_y_d) durch eine Auswahl der Zeile, mit der die Zeilenanforderung (req_y) assoziiert ist, durch ein Auswahlsignal konditioniert wird,
   und wobei die abgeleiteten Zeilenanforderungen dann zu aktivierten abgetasteten Zeilenanforderungen abgetastet werden.

7. Verfahren nach einem der Ansprüche 1 bis 6, wobei die Zustandsmaschine (24) eine Abtastanforderung (clk_req) an eine Schnittstelle (26) sendet, und wobei die Schnittstelle (26) als Reaktion auf die Zeilenanforderung die Zeilenanforderungen auf den Zeilenleitungen abtastet, wobei die Abtastanforderung mit einem Taktsignal synchron ist.

8. Verfahren nach dem vorhergehenden Anspruch, wobei die Zustandsmaschine (24) die Abtastanforderung (clk_req) als Reaktion auf den Zeilenanforderungsindikator (req_y_or) oder als Reaktion auf eine Auslesebestätigung (send_ack_y), dass eine Spaltenschnittstelle bereit ist, Pixelschaltungen einer neuen Zeile auszulesen, oder periodisch während des Auslesens von Pixelschaltungen einer Zeile erzeugt.

9. Verfahren nach einem der zwei vorhergehenden Ansprüche, wobei die Zustandsmaschine (24) die Abtastanforderung in Synchronizität mit einer Bildrate, die durch ein externes Signal definiert ist, erzeugt.

**Revendications**

1. Procédé de fonctionnement d'un capteur d'images basé sur les événements, comprenant une pluralité de circuits de pixels (1) disposés en rangées et en colonnes pour former une matrice de pixels , chaque circuit de pixels (1) étant disposé à un emplacement défini par une adresse, dans lequel chaque circuit de pixels (1) est configuré pour détecter un changement d'illumination dans un signal de photorécepteur dérivé d'un photocourant généré par une lumière frappant un élément sensible à la lumière dudit circuit de pixels (1) et pour activer en conséquence une requête de rangée, dans lequel la matrice de pixels comprend un circuit de lecture couplé aux circuits de pixels par des lignes de rangée, ledit circuit de lecture étant configuré pour recevoir la requête de rangée des circuits de pixels et pour interagir avec les circuits de pixels afin de lire et de réinitialiser lesdits circuits de pixels,

dans lequel, au cours d'un cycle de lecture, une pluralité de circuits de pixels (1) sont lus et réinitialisés rangée par rangée par le circuit de lecture, le procédé étant **caractérisé en ce que** :

- au début du cycle de lecture, les requêtes de rangée (req_y) qui sont activées audit début sont échantillonnées en requêtes de rangée activées échantillonnées (req_y_arb),
- les requêtes de rangée activées échantillonnées (req_y_arb) sont sélectionnées par un ordonnateur (28), et dans chaque rangée avec une requête de rangée activée échantillonnée sélectionnée (ack_y_arb ), chaque circuit de pixel avec une requête de rangée activée est lu et réinitialisé avant qu'une autre ligne avec une requête de rangée activée échantillonnée ne soit sélectionnée, jusqu'à ce que toutes les requêtes de rangée activées échantillonnées (req_y_arb) aient été sélectionnées,

dans lequel les rangées sont associées à un ordre de rangée, et l'ordonnateur (28) sélectionne les requêtes de rangée activées échantillonnées dans une séquence organisée par une règle prédéterminée et basée sur les positions respectives des rangées avec des requêtes de rangée activées échantillonnées dans l'ordre de rangée.

2. Procédé selon la revendication 1, dans lequel la séquence selon laquelle les requêtes de rangée activées échantillonnées sont sélectionnées est indépendant d'un ordre dans lequel les requêtes de rangée ont été activées.

3. Procédé selon l'une quelconque des revendications 1 à 2, dans lequel la règle prédéterminée organisant la séquence comprend un ordre de rangée décroissant ou un ordre de rangée croissant.

4. Procédé selon l'une quelconque des revendications 1 à 3, dans lequel, au cours d'un cycle de lecture, les requêtes de rangée nouvellement activées ne sont pas échantillonnées en requêtes de rangée activées échantillonnées, en raison d'un signal d'arbitre vide indiquant que l'ordonnateur n'est pas vide, l'ordonnateur étant vide lorsqu'aucune requête de rangée n'est en cours de traitement.

5. Procédé selon l'une quelconque des revendications 1 à 4, dans lequel le circuit de lecture comprend une logique d'entrée (22) à laquelle sont couplées les lignes de rangée, et dans lequel le circuit de lecture détecte une requête de rangée (req_y) sur au moins une ligne de rangée et envoie un indicateur de requête de rangée (req_y_or) à une machine d'état pour indiquer qu'au moins une ligne de rangée a une requête de rangée, démarrant ainsi le cycle de lecture.

6. Procédé selon l'une quelconque des revendications 1 à 5, dans lequel le circuit de lecture comprend une logique d'entrée (22), et dans lequel la logique d'entrée (22) traduit les requêtes de rangée activées au début de la lecture en requêtes de rangée dérivées, la traduction d'une requête de rangée (req_y) en une requête de rangée dérivée (req_y_d) étant conditionnée par une sélection de la rangée à laquelle est associée ladite requête de rangée (req_y), par l'intermédiaire d'un signal de sélection,

et dans lequel lesdites requêtes de rangée dérivées sont ensuite échantillonnées en requêtes de rangée activées échantillonnées.

7. Procédé selon l'une quelconque des revendications 1 à 6, dans lequel la machine d'état (24) envoie une requête d'échantillonnage (clk_req) à une interface (26), et dans lequel ladite interface (26), en réponse à ladite requête de rangée, échantillonne les requêtes de rangée sur les lignes de rangée, ladite requête d'échantillonnage étant synchrone avec un signal d'horloge.

8. Procédé selon la revendication précédente, dans lequel la machine d'état (24) génère la requête d'échantillonnage (clk_req) en réponse à l'indicateur de requête de rangée (req_y_or), ou en réponse à une confirmation de lecture (send_ack_y) indiquant qu'une interface de colonne est prête à lire les circuits de pixels d'une nouvelle rangée, ou périodiquement au cours de la lecture des circuits de pixels d'une rangée.

9. Procédé selon l'une quelconque des deux revendications précédentes, dans lequel la machine d'état (24) génère la requête d'échantillonnage en synchronisation avec une fréquence d'images définie par un signal externe.

## FIG 1

## FIG 2

# FIG 3

# FIG 4

a: req_y_or=1
b: req_arb_or=1
c: req_arb_or=0
d: send_ack_y=1
e: ack1reqarb0_or=1 & req_arb_or=0 & req_y_or=0
f: ack1reqarb0_or=1 & req_arb_or=0 & req_y_or=1
g: ack1reqarb0_or=1 & req_arb_or=1
h: ack1reqarb0_or=0


I:      clk_req=1
II:     arb_empty=0
        row_valid=1
        clk_ack=1
III:    arb_empty=0
IV:     row_valid=0
        clk_req=1
V:      arb_empty=1
        clk_ack=1
VI:     arb_empty=1
        clk_req=1
        clk_ack=1
VII:    row_valid=1
        clk_ack=1
VIII:   clk_req=1

# FIG 5

# FIG 6

# FIG 7

# FIG 8

# FIG 9

# FIG 10

| header | payload |
|---|---|
| 2bit | 16bit |

| | | |
|---|---|---|
| 0 | 0 | number of empty vectors (1 ... $2^{16}$) |
| 0 | 1 | 16bit vector of on-events |
| 1 | 0 | 16bit vector of off-events |

# FIG 11

**EP 4 387 259 B1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 2021258525 A1
- US 7728269 B
- US 8780240 B